# DEMANDE DE BREVET EUROPEEN

(11) **EP 0 887 668 A1**
(43) Date de publication de la demande: **30.12.1998**
(21) Numéro de dépôt: 98401495.1
(22) Date de dépôt: 18.06.1998
(51) Int. Cl.: G02B 6/124, G02B 6/136, H01S 3/085

(54) **Réflecteur de bragg en semi-conducteur et procédé de fabrication**

(30) Priorité: 26.06.1997 FR 9708010
(71) Demandeur: ALCATEL ALSTHOM COMPAGNIE GENERALE D'ELECTRICITE, 75008 Paris (FR)
(72) Inventeur: Goldstein, Léon, 92370 Chaville (FR); Bissessur, Hans, 75014 Paris (FR); Bodere, Alain, 91680 Bruyeres le Chatel (FR); Brillouet, Francois, 92140 Clamart (FR); Gentner, Jean Louis, 91190 Gif sur Yvette (FR); Graver, Catherine, 91290 La Norville (FR)
(74) Mandataire: Fournier, Michel Robert Marie

(57) **Abrégé**

L'invention se rapporte à un réflecteur de Bragg en semi-conducteur et à son procédé de fabrication. Le réflecteur selon l'invention comporte plusieurs couches empilées sur un substrat (10) en matériau de type III-V, une desdites couches empilées formant un réseau holographique (81). Il est caractérisé en ce que ladite couche formant le réseau (81) comprend une alternance de trous d'air (62) et de matériau de type III-V (70). Un tel réflecteur est destiné à être utilisé notamment dans des dispositifs laser.

## Description

La présente invention se rapporte à un réflecteur de Bragg en semi-conducteur et à son procédé de fabrication. Les réflecteurs de Bragg sont couramment utilisés notamment dans le domaine des transmissions optiques. Ils permettent de réfléchir une partie de la lumière qu'ils reçoivent.

Un réflecteur de Bragg est plus particulièrement défini par un réseau périodique constitué de deux matériaux possédant des indices de réflexion différents. Le taux de réflexion d'un tel dispositif dépend à la fois de la différence d'indice entre les deux matériaux de constitution et de la géométrie du réseau. Il est en effet proportionnel au produit κ*L, L étant la longueur du réseau et κ étant un coefficient, dénommé "coefficient de Bragg", lié d'une part à la différence d'indice entre les deux matériaux et d'autre part à l'épaisseur du réseau.

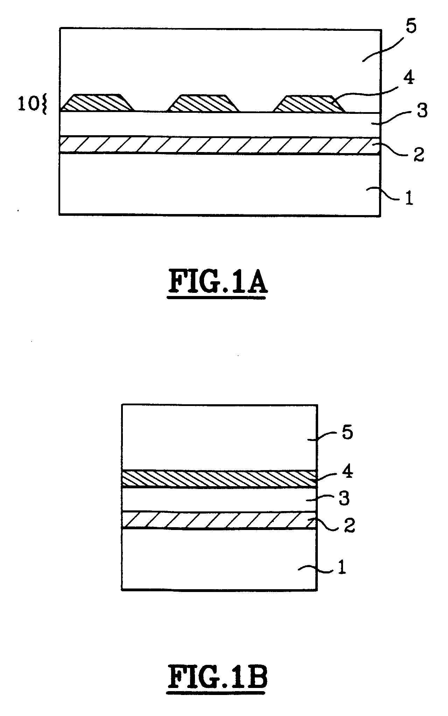

Un réflecteur classique est représenté en coupe transversale suivant le sens de la longueur sur la figure 1A et en coupe transversale suivant le sens de la largeur sur la figure 1B. Ce réflecteur peut par exemple être disposé en regard d'une cavité laser, de manière à réfléchir une partie de l'onde lumineuse émise par cette cavité laser pour réalimenter cette dernière et permettre son oscillation en continu.

Ce réflecteur est réalisé sur des couches 2,3 empilées par épitaxie sur un substrat 1. Le substrat 1 est en général réalisé en phosphure d'indium (InP) dopé en porteurs de type n. Il peut être recouvert d'une couche tampon destinée à faciliter la croissance par épitaxie des différentes couches à empiler. Cette couche tampon n'est pas représentée sur les figures 1A et 1B. Les couches empilées remplissent différentes fonctions optiques. Dans l'exemple représenté sur les figures 1A et 1B, une couche active 2, encore dénommée guide d'onde, est déposée sur le substrat 1. Cette couche active 2 est enterrée dans une couche 3 dite couche de gaine inférieure et réalisée dans un matériau de type III -V tel que de l'InP.

Le réseau de Bragg est référencé 10 sur la figure 1A. Il comporte un matériau 4 à base d'InP, comme par exemple un matériau quaternaire de type GaInAsP, représenté en hachuré sur les figures 1A et 1B, et un matériau 5 d'InP constitutif d'une couche de gaine supérieure.

Ce réseau est réalisé en faisant croître par épitaxie, sur la couche de gaine inférieure, une couche 4 du matériau quaternaire, en gravant cette couche 4 selon une configuration crénelée, puis en rebouchant les créneaux formés par une couche de gaine supérieure d'InP 5 dopé en porteurs de type p. Le matériau quaternaire de GaInAsP 4 et l'InP 5 possédant des indices de réfraction différents, qui sont respectivement égaux à 3,3 et à 3, le réseau holographique 10 ainsi formé permet de réfléchir partiellement l'onde lumineuse qu'il reçoit.

Lorsque l'on souhaite par exemple réaliser un émetteur de multiplexage en longueur d'onde, encore dénommé émetteur WDM ("Wavelength Division Multiplexing"), la longueur L du réseau de Bragg doit être la plus courte possible pour éviter une trop grande réflexion. En effet, plus le réseau est long, plus la réflexion est élevée. Or la réflexion moyenne d'un réseau de Bragg ne doit pas dépasser 30%.

De plus, un réseau à fort saut d'indice présente l'avantage de pouvoir être utilisé pour un grand nombre de longueurs d'onde car il permet d'obtenir une réflexion dans une large fenêtre spectrale.

Un but de l'invention consiste donc à réaliser un réflecteur de Bragg en semi-conducteur à fort saut d'indice et à fort taux de réflexion (de l'ordre de 30%) sur une petite longueur L, typiquement inférieur ou égale à 10µm. Pour cela, le réseau de Bragg doit présenter un coefficient κ très élevé. Or, ce coefficient κ étant lié au saut d'indice et à l'épaisseur du réseau, le réseau doit donc présenter un très fort saut d'indice et/ou une épaisseur importante.

Plusieurs solutions ont déjà été envisagées dans l'art antérieur pour réaliser un réflecteur de Bragg en semi-conducteur à fort saut d'indice et à forte réflexion sur une petite longueur.

Ainsi, une première solution consiste à augmenter la valeur du saut d'indice entre les deux matériaux constitutifs du réseau. Pour cela, on remplace la couche 4 de matériau quaternaire par un autre matériau à base d'indium et/ou de phosphore et ayant un indice de réfraction plus élevé. Cependant, les deux matériaux utilisés pour réaliser le réseau étant tous deux à base d'indium et/ou de phosphore, les indices de réfraction varient très peu. Ils sont en général compris entre 3 et 3,4. La valeur du saut d'indice est par conséquent très limitée. Elle est en général de l'ordre de 0,4 et ne peut dans tous les cas excéder la valeur 1.

Une autre solution, plus courante, consiste à augmenter l'épaisseur du réseau de telle manière que l'onde lumineuse perçoive un contraste le plus important possible. Ce contraste est lié à la fois à la nature du matériau et à l'épaisseur du réseau, c'est à dire à l'épaisseur de la couche du matériau quaternaire. Cependant, cette solution ne permet pas non plus de réaliser un réflecteur présentant les performances désirées. En effet, si les créneaux réalisés dans le matériau quaternaire sont trop profonds, l'étape de rebouchage devient difficile à exécuter sans dégrader la qualité cristalline du matériau de rebouchage c'est à dire de la couche de gaine supérieure. Or, lorsque la qualité cristalline de cette couche est affectée, des pertes de propagation lumineuse apparaissent si bien que les performances du dispositif sont amoindries et le coefficient de Bragg K n'augmente pas suffisamment pour obtenir un taux de réflexion élevé.

Une troisième solution ayant été étudiée consiste à pratiquer une tranchée dans l'échantillon, à l'entrée du réflecteur. Cette tranchée est réalisée de telle sorte qu'elle traverse les couches formant le réseau. Dans ce cas, la longueur de cette tranchée doit être parfaitement contrôlée pour obtenir une réflexion partielle de la lumière permettant la création d'une interférence constructive. Les conditions sur la géométrie de cette tranchée sont donc très sévères et très difficiles à maîtriser avec la technologie actuelle. En conséquence, cette solution ne peut pas être envisagée favorablement.

La présente invention permet de pallier les inconvénients précités puisqu'elle propose un procédé simple de fabrication d'un réflecteur de Bragg de courte longueur et à très fort saut d'indice.

Un premier objet de l'invention concerne un procédé de fabrication d'un réflecteur de Bragg sur des couches empilées par épitaxies sur un substrat en matériau de type III-V, caractérisé en ce qu'il consiste à :
a - déposer, sur une desdites couches empilées, une couche d'arrêt en matériau quaternaire,
b - déposer, sur ladite couche d'arrêt, une couche de gaine inférieure,
c - déposer, sur ladite couche de gaine inférieure, une couche en matériau ternaire,
d - graver localement et sélectivement la couche en matériau ternaire selon une configuration crénelée déterminée,
e - déposer une couche de gaine supérieure, afin de reboucher les créneaux formés et de créer un premier réseau holographique,
f- graver latéralement la couche de gaine supérieure, la couche en matériau ternaire et la couche de gaine inférieure, jusqu'à atteindre la couche d'arrêt, de manière à former un ruban,
g - graver le premier réseau holographique par voie humide pour éliminer de manière sélective ledit matériau ternaire et réaliser une autre structure réseau à fort saut d'indice.

De préférence, le matériau constitutif du substrat et des couches de gaine inférieure et supérieure est de l'InP.

Un autre objet de l'invention concerne un réflecteur de Bragg comportant plusieurs couches empilées sur un substrat en matériau de type III-V, une desdites couches empilées formant un réseau holographique, caractérisé en ce que ladite couche formant le réseau comprend une alternance de trous d'air et de matériau de type III-V.

De préférence la couche formant le réseau holographique se présente sous la forme d'un ruban d'une largeur comprise entre 2,5 et 3,5µm et d'une longueur inférieure ou égale à 10 µm.

Le procédé selon l'invention permet donc de réaliser un réseau de Bragg à très fort saut d'indice. En effet l'InP ayant un indice de réfraction égal à 3 et l'air ayant un indice de réfraction égal à 1, la valeur du saut d'indice du réflecteur est égale à 2. Cette valeur est bien supérieure à celle du saut d'indice entre deux matériaux à base d'InP. Cette augmentation du saut d'indice entraîne une augmentation du coefficient de Bragg d'un facteur 10. Le réflecteur selon l'invention présente un taux de réflexion élevé, de l'ordre de 30%.

Le ruban gravé dans le réflecteur selon l'invention peut être plus ou moins profond et peut comporter une ou plusieurs autres couches présentant d'autres fonctions optiques. Cependant, selon la profondeur de gravure de ce ruban, c'est à dire selon que le ruban comporte une autre fonction optique comme par exemple un guide d'onde, le réflecteur ne sera pas destiné aux mêmes applications. Dans un cas le réflecteur est utilisé dans des dispositifs laser alors que dans un autre cas il est utilisé dans des modulateurs ou dans des guides d'ondes.

D'autres particularités et avantages de l'invention apparaîtront à la lecture de la description suivante donnée à titre d'exemple illustratif mais non limitatif et faite en regard des figures annexées qui représentent :
- les figures 1A et 1B, déjà décrites, respectivement une vue en coupe transversale suivant le sens de la longueur et une vue en coupe transversale suivant le sens de la largeur d'un réflecteur de Bragg classique,
- les figures 2A à 2E, différentes vue d'un réflecteur de Bragg selon l'invention au cours des différentes étapes de sa fabrication,
- la figure 3, une vue en perspective d'un réflecteur de Bragg selon une variante de réalisation.

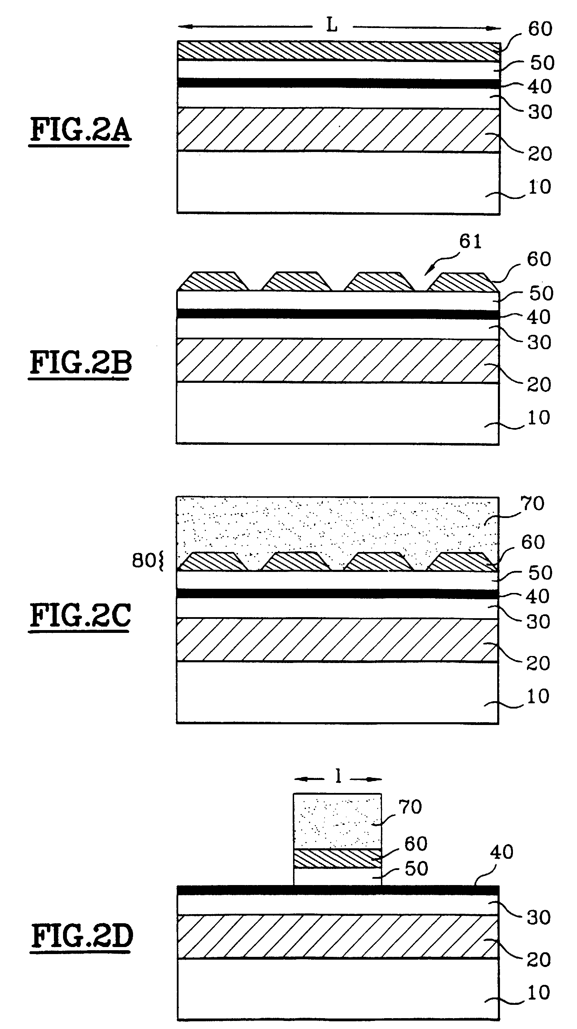

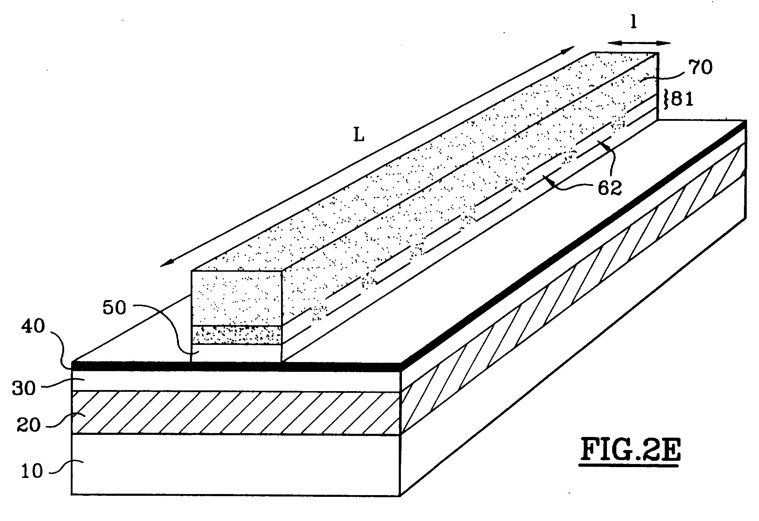

Les figures 2A à 2C représentent des vues en coupe transversale suivant le sens de la longueur d'un réflecteur selon l'invention au cours de sa fabrication, la figure 2D représente une vue en coupe transversale suivant le sens de la largeur, et la figure 2E représente une vue en perspective du dispositif entièrement réalisé.

Une première phase du procédé consiste à réaliser une structure verticale telle que représentée sur la figure 2A. Pour cela, on fait croître, par épitaxie, plusieurs couches successives 20, 30, 40, 50, 60 sur un substrat 10 en matériau de type III-V, tel que de l'InP par exemple. De préférence, le substrat 10 est réalisé dans de l'InP dopé en porteurs d'un premier type, par exemple en porteurs de type n. Le substrat 10 peut bien sûr être recouvert d'une couche tampon destinée à faciliter la croissance des différentes couches à empiler. Cette couche tampon n'est pas représentée sur la figure 2A.

Dans l'exemple représenté sur la figure 2A, la couche 20 recouvrant le substrat 10 constitue un guide d'onde, encore dénommé couche active. Elle comprend de préférence une alternance de couches d'InP et de couches en matériau quaternaire. Dans un exemple de réalisation elle comprend 20 couches d'InP d'épaisseur égale à 100Å (1Å = 10⁻¹⁰ mètres) alternées avec 20 couches de matériau quaternaire d'épaisseur égale à 100Å.

La couche 30, quant à elle, est par exemple réalisée dans du phosphure d'indium (InP) et permet d'enterrer la couche active. Elle est déposée sur une épaisseur de l'ordre de 300Å.

La couche 40 constitue une couche d'arrêt. Elle est de préférence réalisée dans un matériau quaternaire, de type GAInAsP par exemple, sur une épaisseur de l'ordre de 50Å. Son utilité est décrite ci-dessous, au regard de la figure 2D.

La couche 50 constitue une couche de gaine inférieure. Elle est de préférence réalisée en InP sur une épaisseur de l'ordre de 450Å.

Enfin, la couche 60 est destinée à être utilisée pour former le réseau holographique du réflecteur. Elle est de préférence réalisée dans un matériau ternaire, de type GaInAs par exemple, et présente une épaisseur de 1000Å.

Cette structure verticale est réalisée sur une longueur inférieure ou égale à 10µm. Cette longueur est très courte comparée à celle d'une cavité laser qui est en général de l'ordre de 600µm.

Après avoir réalisé la structure verticale, une phase ultérieure du procédé de fabrication consiste à réaliser le réseau holographique. Pour cela, on réalise, dans un premier temps, une gravure locale et sélective de la couche 60 en matériau ternaire selon une configuration déterminée du réseau (figure 2B). Il se forme alors des créneaux 61, dans la couche de matériau ternaire, laissant apparaître la couche de gaine inférieure 50. Cette gravure est par exemple réalisée par voie humide, au moyen d'une solution maintenue à 0°C comprenant de l'acide sulfurique, de l'eau oxygénée et de l'eau dans les proportions respectives suivantes: 10:1:1. Le temps de gravure est très court puisqu'il ne doit pas excéder 3 secondes. Préalablement, on dépose, sur la surface de la couche en matériau ternaire 60, une résine classique destinée à servir. de masque au cours de la gravure. Dans une variante de réalisation, il est tout à fait possible d'envisager utiliser un procédé classique de gravure sèche.

Les créneaux 61 ainsi formés dans la couche 60 de matériau ternaire sont ensuite rebouchés en faisant croître une couche de gaine supérieure 70. Cette couche de gaine supérieure est de préférence réalisée dans le même matériau que la couche de gaine inférieure 50, c'est à dire en InP. Elle est d'autre part dopée en porteurs d'un deuxième type, c'est à dire en porteurs de type p dans l'exemple des figures 2A à 2E. L'épaisseur de la couche de matériau ternaire 60 étant de l'ordre de 100 nm, elle est suffisamment faible pour éviter les problèmes de dégradation de la qualité cristalline du matériau de rebouchage 70.

Ce rebouchage des créneaux 61 par la couche de gaine supérieure 70, tel qu'illustré sur la figure 2C, permet ainsi de réaliser une couche 80 enterrée présentant une structure de réseau holographique. Cette couche 80 comporte deux matériaux possédant des indices de réfraction différents. Elle est en effet composée du matériau ternaire GaInAs 60 n'ayant pas été enlevé au moment de la gravure et du matériau III-V d'InP constitutif de la couche de gaine supérieure 70.

La structure réseau 80 ainsi obtenue est ensuite gravée latéralement de manière à former un ruban, comme représenté sur la figure 2D. Pour cela, la couche de gaine supérieure 70, la couche en matériau ternaire 60 et la couche de gaine inférieure 50 sont gravées latéralement, jusqu'à atteindre la couche d'arrêt 40. La gravure du ruban est de préférence réalisée au moyen d'un procédé classique de gravure sèche, comme par exemple un procédé d'attaque par des ions réactifs encore dénommé procédé RIE ("Reactive Ion Etching") en littérature anglo-saxonne n'attaquant pas, ou très difficilement, la couche d'arrêt 40 en matériau quaternaire. Ainsi, la gravure du ruban s'arrête sur la couche d'arrêt 40. Le ruban présente de préférence une largeur 1 comprise entre 2,5 et 3,5 µm.

Enfin, la dernière étape du procédé de fabrication selon l'invention est essentielle pour obtenir un réseau de Bragg à très fort saut d'indice. Elle consiste en effet à graver la structure de réseau holographique 80 d'InP/InGaAs pour éliminer de manière sélective le matériau ternaire 60 d'InGaAs. Il se forme alors périodiquement des trous d'air, référencés 62 sur la figure 2E, à la place du matériau ternaire.

Cette gravure sélective permet de remplacer la première structure réseau 80 par une deuxième structure réseau, référencée 81 sur la figure 2E, composée dé trous d'air 62 et d'InP 70 et présentant un très fort saut d'indice, bien supérieur à celui du réseau d'InP/InGaAs. En effet, tandis qu'un réseau holographique d'InP/InGaAs présente un saut d'indice de l'ordre de 0,3 le réseau holographique 81 du réflecteur selon l'invention présente un saut d'indice égal à 2 puisqu'il est composé d'InP dont l'indice de réfraction est égal à 3 et d'air dont l'indice de réfraction est égal à 1. Ce fort saut d'indice permet en outre d'augmenter le coefficient de Bragg K d'un facteur 10.

De manière avantageuse, la gravure sélective du réseau est réalisée par voie humide au moyen d'une solution apte d'une part à attaquer rapidement le matériau ternaire de GaInAs afin de former des trous d'air dans la structure réseau et d'autre part à attaquer très lentement le matériau quaternaire de GaInAsP formant la couche d'arrêt 40 et l'InP formant les couches de gaine inférieure 50 et supérieure 70.

Cette solution est maintenue à 0°C et comprend de préférence de l'acide sulfurique, de l'eau oxygénée et de l'eau dans les proportions respectives suivantes:1:3:10. La gravure est réalisée pendant une durée comprise entre 40 et 50 secondes, de préférence pendant un durée égale à 45 secondes. Avec une telle solution, l'attaque du matériau ternaire est environ 10 fois plus rapide que celle du matériau quaternaire ou celle de l'InP.

Le réseau holographique 81 d'InP/trous d'air est réalisé sur une épaisseur correspondant à celle de la couche 60 en matériau ternaire, c'est à dire sur une épaisseur de l'ordre de 100 nm.

Le pas du réseau est déterminé selon la longueur d'onde de l'onde lumineuse à réfléchir. Ainsi, lorsque le réflecteur de Bragg est utilisé dans un dispositif laser par exemple le pas du réseau est tel que la longueur d'onde de l'onde réfléchie vers la cavité laser se situe autour de 1,55µm. Dans ce cas, le pas du réseau est donc compris entre 237 et 240 nm.

Le réflecteur de Bragg ainsi réalisé permet l'obtention d'un taux de réflexion de 30%. De plus, du fait du fort saut d'indice, la réflexion est large, c'est à dire que la réflexion de 30% est obtenue dans une large fenêtre spectrale. La largeur de cette fenêtre spectrale est en effet comprise entre 25 et 30 nm. Par conséquent, ce réflecteur de Bragg présente en outre l'avantage de pouvoir être utilisé pour un grand nombre de longueurs d'onde.

Le réflecteur qui vient d'être décrit présente un ruban peu profond puisque seul le réseau holographique est gravé sous la forme d'un ruban. On dit encore qu'il est de type "shallow ridge" en littérature anglo-saxonne. Il est utilisé notamment dans les dispositifs laser pour réalimenter la cavité laser en énergie lumineuse et la faire osciller de manière continue.

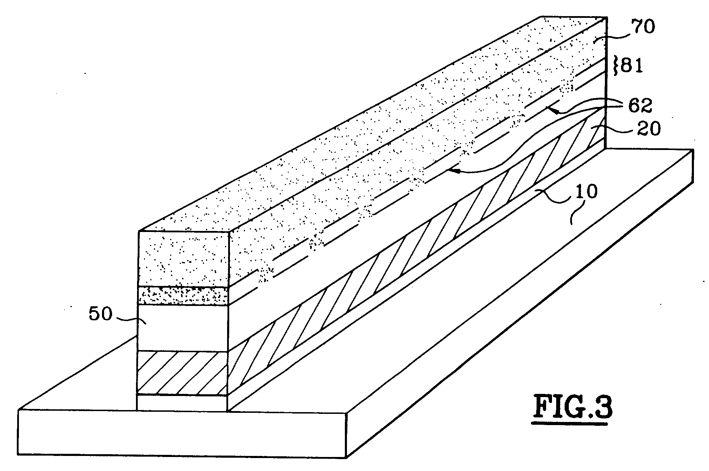

Un réflecteur de Bragg selon une variante de réalisation est représenté en perspective sur la figure 3. Dans cette variante, seule la géométrie du ruban change. En effet, la gravure latérale est prolongée de manière à ce que la couche active 20 se présente également sous forme de ruban. La gravure du ruban peut se faire en une seule fois au moyen d'un procédé de gravure sèche, par attaque d'ions réactifs par exemple.

Dans ce cas, la couche active n'étant plus protégée par la couche 30 d'InP, il est d'autant plus important que l'étape de gravure du premier réseau holographique d'InP/GaInAs, permettant d'éliminer GaInAs et de le remplacer par des trous d'air, soit très sélective et n'attaque pas, ou très lentement, l'InP et le matériau quaternaire de GaInAsP composant cette couche active 20 pour ne pas la détériorer.

Le ruban formé est alors très profond, on dit encore que le réflecteur est de type "deep ridge" en littérature anglo-saxonne. Ce type de réflecteur ne peut être utilisé dans les dispositifs laser, en revanche il est utilisé dans des modulateurs ou encore dans des guides d'onde.

## Revendications

1. Procédé de fabrication d'un réflecteur de Bragg en semi-conducteur sur des couches empilées (20, 30), déposées successivement par épitaxie sur un substrat (10) en matériau de type III - V, caractérisé en ce qu'il consiste à :
a - déposer, sur une desdites couches empilées (30), une couche d'arrêt en matériau quaternaire (40),
b - déposer sur ladite couche d'arrêt (40), une couche de gaine inférieure (50),
c - déposer, sur ladite couche de gaine inférieure (50) une couche en matériau ternaire (60),
d - graver localement et sélectivement la couche en matériau ternaire (60) selon une configuration crénelée déterminée,
e - déposer une couche de gaine supérieure (70) afin de reboucher les créneaux (61) formés et de créer un premier réseau holographique (80),
f- graver latéralement la couche de gaine supérieure (70), la couche en matériau ternaire (60) et la couche de gaine inférieure (50), jusqu'à atteindre la couche d'arrêt (40), de manière à former un ruban,
g - graver le premier réseau holographique (80) par voie humide pour éliminer de manière sélective ledit matériau ternaire (60) et réaliser une autre structure réseau (81) à fort saut d'indice.

2. Procédé selon la revendication 1, caractérisé en ce que la gravure sélective par voie humide du premier réseau holographique (80) est réalisée au moyen d'une solution maintenue à 0°C et comportant de l'acide sulfurique, de l'eau oxygénée et de l'eau dans les proportions respectives suivantes: 1:3:10.

3. Procédé selon l'une des revendications 1 à 2, caractérisé en ce que la gravure sélective par voie humide du premier réseau holographique (80) est réalisée pendant une durée comprise entre 40 et 50 secondes.

4. Procédé selon l'une des revendications 1 à 3, caractérisé en ce que la couche de matériau ternaire (60) est réalisée dans du GaInAs.

5. Procédé selon l'une des revendications 1 à 4, caractérisé en ce que le substrat (10) et les couches de gaine inférieure (50) et supérieure (70) sont réalisés dans un matériau III - V tel que l'InP.

6. Procédé selon l'une des revendications 1 à 5, caractérisé en ce que la couche d'arrêt (40) est réalisée dans du GaInAsP.

7. Procédé selon l'une des revendications 1 à 6, caractérisé en ce qu'il comprend en outre une étape supplémentaire consistant à prolonger la gravure latérale du ruban dans les couches empilées (20, 30).

8. Réflecteur de Bragg en semi-conducteur comportant plusieurs couches empilées sur un substrat (10) en matériau de type III-V, une desdites couches empilées formant un réseau holographique (81), caractérisé en ce que ladite couche formant le réseau comprend une alternance de trous d'air (62) et de matériau de type III-V (70).

9. Réflecteur de Bragg selon la revendication 8, caractérisé en ce que le matériau de type III-V (70) est de l'InP.

10. Réflecteur de Bragg selon l'une des revendications 8 à 9, caractérisé en ce que la couche formant le réseau holographique (81) présente une épaisseur de l'ordre de 100 nm.

11. Réflecteur de Bragg selon l'une des revendications 8 à 10, caractérisé en ce que la couche formant le réseau (81) se présente sous la forme d'un ruban de largeur comprise entre 2,5 et 3,5 µm et de longueur inférieure ou égale à 10µm
